Europäisches Patentamt

European Patent Office

Office européen des brevets

(11) Veröffentlichungsnummer: **0 060 992**
**B1**

(12) # EUROPÄISCHE PATENTSCHRIFT

(45) Veröffentlichungstag der Patentschrift:
**07.01.87**

(21) Anmeldenummer: **82101038.6**

(22) Anmeldetag: **12.02.82**

(51) Int. Cl.⁴: **G 01 R 19/145,** H 03 K 17/945,
H 03 K 19/003

(54) **Prüf- und Auswerteschaltung für Näherungsschalter in Maschinensteuerungen.**

(30) Priorität: **18.03.81 DE 3110390**

(43) Veröffentlichungstag der Anmeldung:
**29.09.82 Patentblatt 82/39**

(45) Bekanntmachung des Hinweises auf die Patenterteilung:
**07.01.87 Patentblatt 87/2**

(84) Benannte Vertragsstaaten:
**CH DE FR GB IT LI SE**

(56) Entgegenhaltungen:
**EP - A - 0 035 225**
**DE - A - 2 745 650**
**DE - B - 2 150 694**
**DE - B - 2 166 021**

(73) Patentinhaber: **Gebhard Balluff Fabrik feinmechanischer Erzeugnisse GmbH & Co., Gartenstrasse 21, D-7303 Neuhausen a.d.F. (DE)**

(72) Erfinder: **Kammerer, Heinz, Ing.-grad., Achalmstrasse 29, D-7302 Ostfildern 2 (DE)**
Erfinder: **Langheinrich, Hans, Dipl.-Ing., Hummelbergweg 38, D-7250 Leonberg-Silberberg (DE)**

(74) Vertreter: **Hoeger, Stellrecht & Partner, Uhlandstrasse 14c, D-7000 Stuttgart 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Prüf- und Auswerteschaltung für die einwandfreie Funktion eines als Element einer Maschinensteuerung vorgesehenen, durch Änderung seines Schaltzustandes auf seine Funktionsfähigkeit prüfbaren Näherungsschalters.

In der auf einer Anmeldung vom 25. Februar 1981 basierenden, am 9. September 1981 veröffentlichten EP-A-0 035 225, in der folgende Vertragsstaaten benannt sind: AT, BE, CH, FR, GB, IT, LI, NL, SE, wird bereits vorgeschlagen, als Elemente von Maschinensteuerungen zur Überwachung bewegbarer Teile Näherungsschalter einzusetzen, die hinsichtlich ihrer Funktionsfähigkeit prüfbar sind, und zwar speziell induktive oder kapazitive Näherungsschalter, bei denen zur Prüfung der Funktionsfähigkeit ein schaltbarer Bedämpfungskreis vorgesehen ist, mit dessen Hilfe ein einen Eingangskreis des Näherungsschalters bildender Oszillator bedämpfbar ist, der ein von aussen berührungslos beeinflussbares induktives oder kapazitives, frequenzbestimmendes Steuerelement enthält. Dabei wurde davon ausgegangen, dass der Bedämpfungskreis im einfachsten Fall im wesentlichen aus einem Taster besteht, über den ein Teil einer Wicklung eines induktiven Näherungsschalters kurzgeschlossen werden kann, wobei auch in Betracht gezogen wurde, den Dämpfungskreis periodisch zu betätigen, um periodisch eine Überprüfung des Näherungsschalters auf seine Funktionsfähigkeit durchführen zu können, und zwar unter Auswertung der Änderung des Schalterausgangssignals in Abhängigkeit von einem Prüfvorgang. Auf Grund dieser Auswertung wird eine Relaisschaltung gesteuert, die die Maschinensteuerung überwacht.

Aus der DE-A-2 745 650 ist es ferner bekannt, bei einem induktiven Näherungsschalter das Oszillator-Ausgangssignal nach Verstärkung und Frequenzumsetzung über einen Transformator zu einem Gleichrichter zu übertragen, an den ausgangsseitig ein Relais angeschlossen ist. Durch diese Ausgestaltung soll erreicht werden, dass das Relais nur dann anziehen kann, wenn alle Baugruppen des Näherungsschalters, die auf der Eingangsseite des Transformators liegen, einwandfrei arbeiten, da nur in diesem Fall auf der Eingangsseite des Transformators eine Wechselspannung erscheint, die transformiert und auf der Sekundärseite des Transformators gleichgerichtet werden kann. Eine «aktive Prüfung» des Näherungsschalters durch künstliches Be- und Entdämpfen des Oszillators ist dabei nicht möglich. Ausserdem ist es ein Nachteil der bekannten Lösung, dass das nicht in die interne Überwachung einbezogene Relais das empfindlichste von allen eingesetzten Bauelementen ist und beispielsweise bei Verschweissen seiner Kontakte «hängen bleiben» kann, wodurch für nachgeschaltete Schaltkreise ein Schwingen des Oszillators des Näherungsschalters simuliert wird, was zur Auslösung gefährlicher Schaltvorgänge in einer Maschinensteuerung führen kann.

Weiterhin ist es aus der DE-B-2 166 021 bekannt, für einen Näherungsschalter eine Auswerteschaltung vorzusehen, die bei ordnungsgemäss funktionierendem Näherungsschalter ein Ausgangssignal in Form eines stetigen Prüfsignals liefert, welches bei Störungen des Schalters unterbrochen wird. Auch bei diesem Näherungsschalter ist kein gezieltes Be- und Entdämpfen des Näherungsschalters zur Prüfung seiner Funktionsfähigkeit möglich. Ausserdem besteht die Gefahr, dass das stetige Prüfsignal aufgrund eines Schaltungsfehlers vorgetäuscht wird.

Schliesslich ist es aus der DE-B-2 150 604 bekannt, in einem berührungslosen Sicherheitsschalter ein rechteckförmiges Signal zu erzeugen, mit dem eine eine Maschinensteuerung überwachende Relaisschaltung angesteuert wird.

Obwohl gemäss dem früheren Vorschlag bereits eine erhebliche Sicherheit gegen das Auftreten unerwarteter Störungen erreichbar ist, hat es sich gezeigt, dass die früher vorgeschlagene Lösung nicht in allen Fällen voll befriedigen kann.

Der Erfindung lag daher die Aufgabe zugrunde, ausgehend von dem früheren Vorschlag eine verbesserte Prüf- und Auswerteschaltung für prüfbare Näherungsschalter anzugeben, die eine kontinuierliche Überwachung des störungsfreien Betriebes des Näherungsschalters selbst und der Elemente der Prüf- und Auswerteschaltung gestattet.

Diese Aufgabe wird gelöst durch eine Prüf- und Auswerteschaltung für die einwandfreie Funktion eines als Element einer Maschinensteuerung vorgesehenen, durch Änderung seines Schaltzustandes auf seine Funktionsfähigkeit prüfbaren Näherungsschalters mit einer Steuerschaltung, durch die der Näherungsschalter mit einer solchen Frequenz zwischen seinen beiden Schaltzuständen umsteuerbar ist, dass er an seinem Ausgang ein für eine transformatorische Übertragung geeignetes, getaktetes Ausgangssignal erzeugt, und mit einem mit dem Ausgang des Näherungsschalters verbundenen Auswertekreis, der für die Dauer des Vorliegens des getakteten Ausgangssignals des Näherungsschalters ein Freigabesignal und beim Ausbleiben des getakteten Ausgangssignals des Näherungsschalters ein Sperrsignal für die Maschinensteuerung erzeugt und der eine die Maschinensteuerung überwachende Relaisschaltung umfasst, der das getaktete Ausgangssignal des Näherungsschalters bzw. ein davon abgeleitetes Signal über einen zum Auswertekreis gehörigen und zwischen dem Ausgang des Näherungsschalters und der Relaisschaltung liegenden Transformator zuführbar ist.

Der entscheidende Vorteil einer solchen Prüf- und Auswerteschaltung mit einem mit vorgegebener Frequenz arbeitenden Steuerkreis besteht dabei darin, dass beispielsweise bei induktiven und kapazitiven Näherungsschaltern die Bedämpfung des Oszillators mit einer vergleichsweise hohen Frequenz von beispielsweise 140 Hz erfolgen kann, so dass am Ausgang des Näherungsschalters ständig eine Wechselspannung zur Verfügung steht, solange keine Bedämpfung des Näherungsschalters durch ein bewegliches Teil erfolgt und solange keine Störung vorliegt. Hierdurch wird aber in Ausgestaltung der Erfindung die Möglichkeit eröffnet, das in Form einer Wechselspannung bzw. einer Rechteck-Impulsfolge vorliegende Ausgangssignal des Näherungsschalters, welches bei einem optischen Näherungsschalter beispielsweise durch getaktetes Ein- und Ausschalten eines Lichtsenders desselben erhalten werden kann, über einen Transformator nachgeschalteten elektrischen Überwachungseinrichtung zuzuführen, wobei allein die Tatsache, dass über den Transformator kontinuierlich ein Signal übertragen wird, bereits anzeigt, dass der vor dem Transformator liegende Näherungsschalter mit seinem zugeordneten astabilen Multivibrator einwandfrei arbeitet.

Weiterbildungen der Erfindung sind in den Ansprüchen 2 bis 13 angegeben.

Bei einer Schaltung gemäss einer Weiterbildung der Erfindung, mit einem Näherungsschalter der in an sich bekannter Weise einen induktiven, eine Tastkopfspule enthaltenen Tastkopf im Schwingkreis des Oszillators aufweist, hat es sich dabei als vorteilhaft erwiesen, wenn für die Tastkopfspule in der einen Schaltstellung des Multivibrators zumindest teilweise ein Kurzschluss herbeiführbar ist, wobei es insbesondere bei einer Tastkopfspule mit einer Anzapfung vorteilhaft ist, wenn durch den Multivibrator für einen zwischen der Anzapfung und einem der äusseren Anschlüsse liegenden Wicklungsteil der Tastkopfspule ein Kurzschluss herbeiführbar ist.

Bei einer solchen Ausgestaltung des Näherungsschalters ist es dann auch besonders vorteilhaft, wenn für die Tastkopfspule bzw. deren Wicklungsteil ein Kurzschluss unmittelbar mittels eines dazu parallel geschalteten, durch den Multivibrator steuerbaren Schalttransistors herbeiführbar ist. Besonders günstig ist es dabei, wenn in Serie zu der Schaltstrecke des Transistors ein definierter Reihenwiderstand eingefügt ist.

Wie bereits angedeutet, ist es in Ausgestaltung der Erfindung auch vorteilhaft, wenn der Ausgang des Näherungsschalters mit dem Eingang einer Ansteuerschaltung verbunden ist, deren Ausgang über einen Transformator mit dem Eingang einer Relaisschaltung verbunden ist, die als Elemente einer Maschinenanlaufsteuerung zwei Relais enthält, die jeweils einen Arbeitskontakt besitzen, und wenn die Arbeitskontakte in Serie zueinander in die Hauptkontaktstrecke des Maschinenstromkreises eingefügt sind.

Weitere Einzelheiten und Vorteile der Erfindung werden nachstehend anhand von Zeichnungen noch näher erläutert und/oder sind Gegenstand von abhängigen Ansprüchen. Es zeigen:

Fig. 1 ein Prinzipschaltbild einer bevorzugten Ausführungsform einer Prüf- und Überwachungsschaltung gemäss der Erfindung;

Fig. 2 ein detailliertes Schaltbild des Näherungsschalters der Schaltung gemäss Fig. 1 mit einer Steuerschaltung und einem Bedämpfungskreis;

Fig. 3 ein detailliertes Schaltbild einer Ansteuerschaltung der Schaltung gemäss Fig. 1;

Fig. 4 ein detailliertes Schaltbild einer Relaisschaltung der Schaltung gemäss Fig. 1 und

Fig. 5 ein Diagramm mit den Spannungsverläufen an verschiedenen wichtigen Punkten der Ansteuerschaltung gemäss Fig. 3.

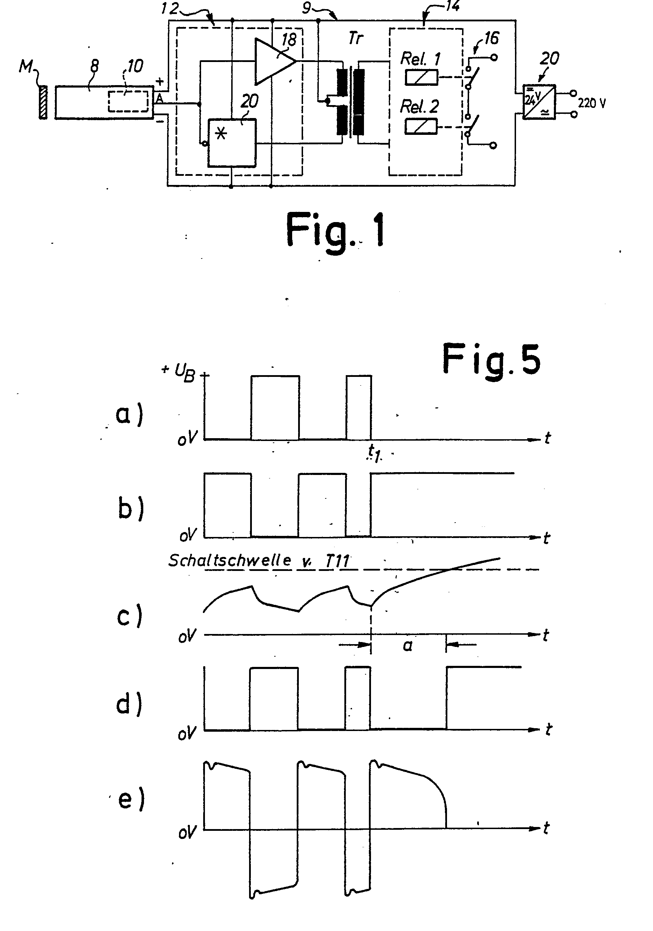

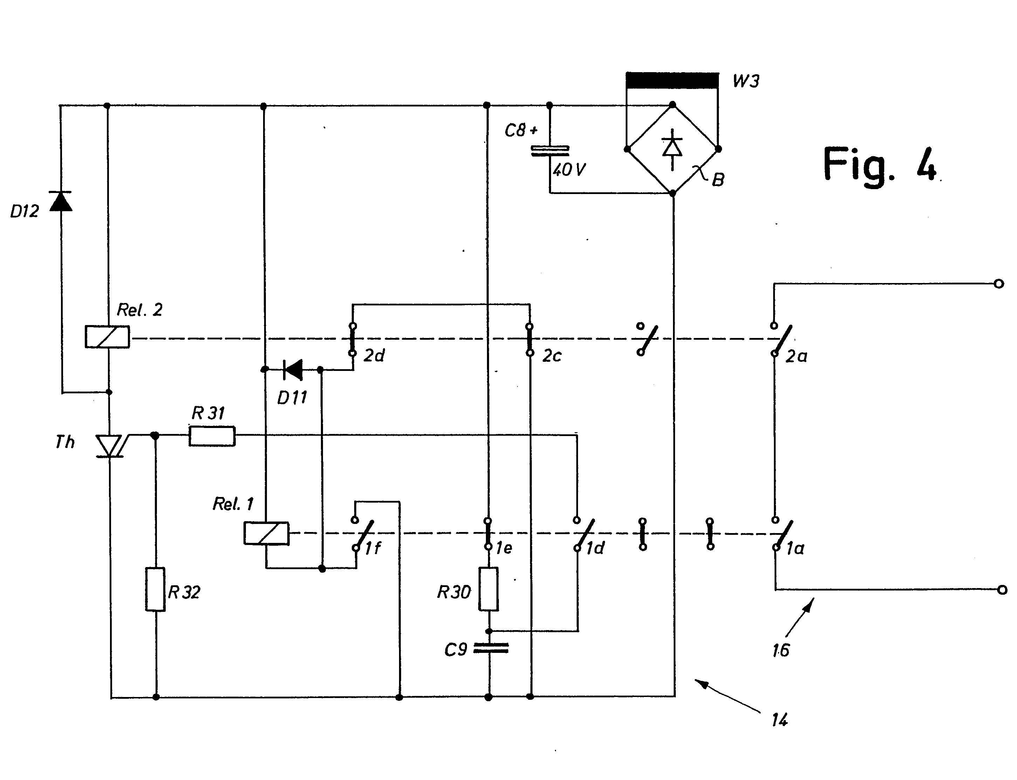

Im einzelnen zeigt Fig. 1 einen prüfbaren Näherungsschalter 8, in welchen beim Ausführungsbeispiel, wie dies durch einen gestrichelt eingezeichneten Block angedeutet ist, eine Steuerschaltung 10 integriert ist, durch die ein Bedämpfungskreis des Näherungsschalters 8 periodisch ein- und ausschaltbar ist. Der Näherungsschalter 8 besitzt einen Ausgang A, der mit einem Eingang einer Ansteuerschaltung 12 verbunden ist, die beim Ausführungsbeispiel aus einem Verstärker 18 und aus einem invertierenden Verstärker 20 aufgebaut ist, wobei der invertierende Verstärker 20 bei einer Funktionsstörung des Näherungsschalters 8 oder einer Bedämpfung desselben bei einem ersten Ausgangspotential des Näherungsschalters 8 ebenso sperrt wie der erste Verstärker 18 bei einem zweiten Potential am Ausgang A des Näherungsschalters 8. Die Ausgänge der beiden Verstärker 18, 20 sind mit einem Transformator Tr verbunden, dessen Primärwicklung bei dem Ausführungsbeispiel gemäss Fig. 1 als Wicklung mit Mittelanzapfung ausgebildet ist. Die Sekundärwicklung des Transformators Tr ist mit dem Eingang einer Relaisschaltung 14 verbunden, welche als wesentliche Elemente zwei Relais Rel 1 und Rel 2 aufweist, die jeweils einen in eine Hauptkontaktstrecke 16 einer Maschinensteuerung eingefügten Arbeitskontakt aufweisen, wie dies weiter unten anhand von Fig. 4 noch ausführlich erläutert werden wird. Insgesamt bilden in Fig. 1 die mit dem Ausgang A des Näherungsschalters 8 verbundenen Schaltungen bzw. Schaltungsteile einen Auswertekreis 9, dem eine Stromversorgung bzw. ein Netzteil 20 zugeordnet ist, aus dem auch der Näherungsschalter 8 selbst gespeist wird.

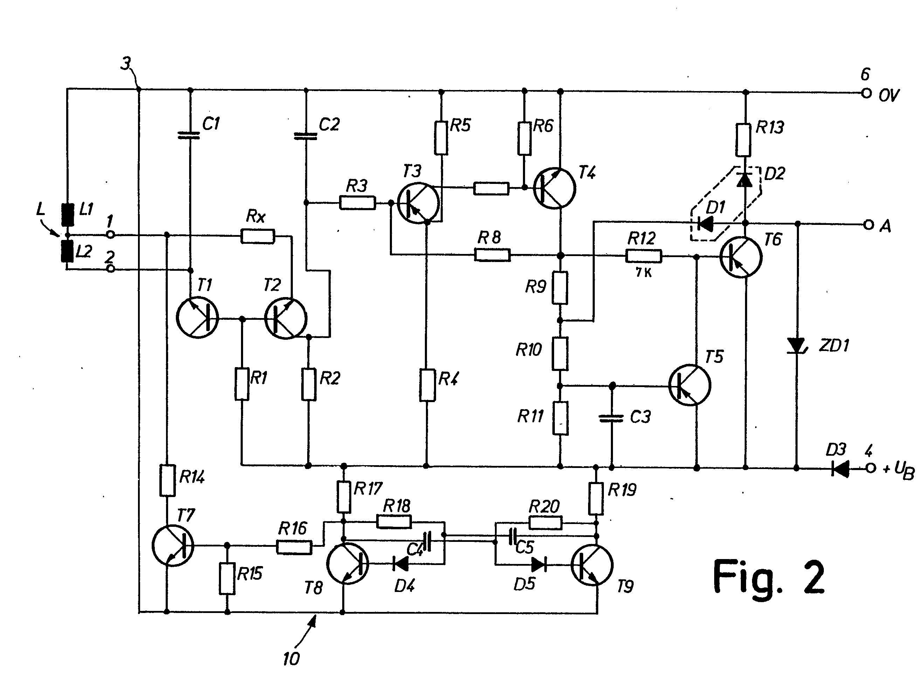

Wie Fig. 2 der Zeichnung zeigt, handelt es sich bei dem zu prüfenden Näherungsschalter zunächst einmal um einen weitgehend üblichen induktiven Näherungsschalter. Dieser Näherungsschalter besitzt eingangsseitig eine Tastkopfspule L, die üblicherweise in einem nach vorn – das heisst in Richtung auf die zu überwachenden beweglichen Teile – offenen Topfkern angeordnet ist. Die Tastkopfspule L besitzt äussere Anschlüsse 2, 3, die mit dem Versorgungsanschluss 6 des Näherungsschalters bzw. mit dem Emitter des Transistors T1 verbunden sind. Parallel zu der Tastkopfspule L liegt ein Kondensator C1, welcher zusammen mit der Tastkopfspule L einen Schwingkreis L, C1 bildet.

Der Oszillator des Näherungsschalters 8 gemäss Fig. 2 weist ferner zwei Transistoren T1 und T2 und drei Widerstände Rx, R1 und R2 auf. Die Basisanschlüsse der Transistoren T1 und T2 sind über den Widerstand R1 mit den Anschluss 4 des Näherungsschalters verbunden. Der Emitter des Transistors T1 ist einerseits mit dem äusseren Anschluss 2 der Tastkopfspule L und andererseits mit dem Kondensator C1 verbunden. Der Kollektor des Transistors T1 ist nicht beschaltet, so dass lediglich die Basis-Emitter-Strecke des Transistors T1 als Diode wirksam ist, wobei jedoch diese Diode in ihren elektrischen Eigenschaften besonders genau auf die Eigenschaften des Transistors T2 abgestimmt werden kann, dessen Kollektor über den Widerstand R2 mit dem Anschluss 4 und dessen Emitter über den Widerstand Rx mit dem Anschluss 1 des Näherungsschalters 8 verbunden ist, das heisst mit einer Anzapfung der Tastkopfspule L, welche durch diese Anzapfungen in zwei Teilwicklungen L1 und L2 unterteilt wird.

Mit dem vorstehend beschriebenen Oszillator ist eine Kippschaltung verbunden, welche einen Kondensator C2, Widerstände R3 bis R11 und zwei weitere Transistoren T3 und T4 aufweist, wobei der Kondensator C2 auch als Bestandteil des Oszillators anzusehen ist.

Von den genannten Bauelementen ist der Kondensator C2 einerseits mit dem Anschluss 6 des Näherungsschalters und andererseits mit dem Kollektor des Transistors T2 verbunden. Der gemeinsame Verbindungspunkt des Transistors T2, des Widerstandes R2 und des Kondensators C2 ist über einen Widerstand R3 mit der Basis des Transistors T3 der Kippschaltung verbunden. Der Emitter dieses Transistors T3, der als pnp-Transistor ausgebildet ist, ist einerseits über den Widerstand R4 mit dem Anschluss 4 und andererseits über den Widerstand R5 mit dem Anschluss 6 des Näherungsschalters verbunden. Der Kollektor des Transistors T3 ist über den Widerstand R7 mit der Basis des Transistors T4 verbunden. Die Basis des Transistors T4 ist ausserdem über den Widerstand R6 mit dem Anschluss 6 verbunden, während der Emitter des Transistors T4 unmittelbar mit dem Anschluss 6 verbunden ist. Der Kollektor des Transistors T4 ist über den Widerstand R8 mit der Basis des Transistors T3 und über die Widerstände R9 bis R11 mit dem Anschluss 4 verbunden und bildet einen Anschluss, der mit dem Ausgang A der Kippschaltung bzw. dem Eingang der damit verbundenen Ansteuerschaltung 12 über den Widerstand R9 und eine Diode D1 verbunden ist.

Bei einem Näherungsschalter der vorstehend beschriebenen Art liegt die Tastkopfspule L normalerweise in einem nach vorn offenen Schalenkern, so dass ein magnetisches Feld mit grosser Streuung aufgebaut werden kann. Bewegt man nun in dieses Feld ein Metallteil M, so fliessen in diesem induzierte Wirbelströme, die dem Feld Energie entziehen. Diese Wirbelstromverluste bewirken eine Verschlechterung der Schwingkreisgüte, so dass sich die Schwingungsamplitude verringert. Mit anderen Worten: der Schwingkreis wird bedämpft.

Wenn der Schwingkreis bzw. der Oszillator schwingt, dann bilden die Elemente R2, T2, Rx und L1 für die Dauer der negativen Halbwelle der Schwingung einen Spannungsteiler. Dabei entsteht am Kollektor des Transistors T2 eine verhältnismässig hohe negative Spannung, weil der Widerstand R2 gegenüber den übrigen Elementen des Spannungsteilers hochohmig ist. Dies hat zur Folge, dass der Kondensator C2 am Eingang der Kippschaltung nur wenig aufgeladen wird. Wenn der Transistor T2 dann während der positiven Halbwelle der Schwingung sperrt, dann lädt sich der Kondensator C2 geringfügig über den Widerstand R2 weiter auf, bis die nächste negative Halbwelle der Schwingung auftritt. Der Kondensator C2 glättet also die Spannung am Kollektor des Transistors T2 bzw. am Eingang der Kippschaltung derart, dass sich eine Gleichspannung mit vernachlässigbarer Restwelligkeit ergibt. Diese Spannung ist so hoch bzw. so weit an OV angenähert, dass der Transistor T3 leitend gesteuert wird, so dass in der Folge auch der Transistor T4 und ein über einen Widerstand R12 mit dessen Kollektor verbundener Transistor T6 leitend gesteuert werden. Da der Emitter des Transistors T6 über eine Diode D3 mit dem Anschluss 4 verbunden ist, ergibt sich somit am Ausgang A des Näherungsschalters, nämlich am Kollektor des Transistors T6, ein positives Potential ($+U_B$) gegenüber dem Anschluss 6. Eine Z-Diode ZD1 parallel zum Transistor T6 schützt diesen Transistor und begrenzt Störspannungsspitzen.

Parallel zur Basis-Emitter-Strecke des Transistors T6 liegt ausserdem noch ein Transistor T5, dessen Basis mit dem gemeinsamen Verbindungspunkt der Widerstände R10 und R11 verbunden ist, die ihrerseits in Reihe mit dem Widerstand R9 zwischen dem Kollektor des Transistors T4 und dem Anschluss 4 des Näherungsschalters 8 liegen. Der gemeinsame Verbindungspunkt der Widerstände R9 und R10 ist dabei über eine Diode D1 mit dem Kollektor des Transistors T6 verbunden, der ausserdem über die Serienschaltung einer weiteren Diode D2 und eines Widerstandes R13 mit dem Anschluss 6 verbunden ist.

Wird durch die Bedämpfung des Oszillators die Schwingungsamplitude kleiner, dann lädt sich der Kondensator C2 auf eine höhere Spannung auf, wobei der Spannungspegel überschritten wird, der erforderlich ist, um die Kippschaltung in den Aus-Zustand zu kippen. Dabei ist das Emitterpotential des Transistors T3 durch die Widerstände R4 und R5 im wesentlichen festgelegt, und zwar derart, dass die Ausschaltschwelle bzw. die Einschaltschwelle im wesentlichen dem Emitterpotential entspricht, wenn man den Spannungsabfall an R3 sowie die Basis-Emitter-Spannung $U_{BE}$ vernachlässigt. Durch der Spannungsanstieg am Kondensator C2 sperrt also der Transistor T3, wodurch auch die nachgeschalteten Transistoren T4 und T6 in den nichtleitenden Zustand überführt werden, da ihnen kein Basisstrom mehr zugeführt werden kann. Damit sinkt aber der Pegel des Ausgangssignals am Ausgang A des Näherungsschalters 8 praktisch auf den Wert von OV.

Wird nun ein Näherungsschalter der betrachteten Art, bei dem der Widerstand Rx der individuellen Einstellung des Ansprechabstandes zwischen der aktiven Fläche des Tastkopfes und dem zu überwachenden beweglichen Element dient, zur Überwachung von Sicherheitseinrichtungen an Maschinen benutzt, dann kann ein Defekt verhängnisvolle Folgen haben. Es sind zwar dann keine Schäden möglich, wenn eine Bedämpfung vorgetäuscht wird und ein durch den Näherungsschalter gesteuertes Relais abfällt, da in diesem Fall eine Maschinenstörung vorgetäuscht wird und die Maschine nicht anlaufen kann bzw. stillgesetzt wird. Wird jedoch trotz einer tatsächlich vorhandenen Bedämpfung eine Schwingung vorgetäuscht, was beispielsweise bei einem Durchschlagen der Transistoren T3, T4 oder T6 der Fall ist, dann kann die Maschine trotz der Störung anlaufen, was möglicherweise schwere Sachschäden oder sogar Personenschäden zur Folge hat. Aus diesem Grunde wurde bereits vorgeschlagen (EP-A-0 035 225), dem Näherungsschalter 8 bzw. dem Oszillator desselben einen Bedämpfungskreis zuzuordnen, mit dem zu Prüfzwecken, gegebenenfalls periodisch, eine Bedämpfung des Oszillators herbeigeführt werden kann, um zu überprüfen, ob eine solche Bedämpfung tatsächlich einen Signalwechsel am Ausgang des Näherungsschalters zur Folge hat, wobei ein solcher Signalwechsel die Funktionsfähigkeit des Näherungsschalters anzeigt.

Es hat sich jedoch gezeigt, dass eine solche periodische Bedämpfung in einigen Fällen noch nicht hinreichend sicher ist und dass eine kontinuierliche Überwachung der Funktionsfähigkeit des Näherungsschalters wünschenswert wäre. Um eine solche kontinuierliche Prüfung zu ermöglichen, ist nun gemäss einem Merkmal der Erfindung dem Näherungsschalter 8 eine Steuerschaltung 10 zugeordnet, die in den Näherungsschalter selbst integriert werden kann, die aber auch im Abstand vom eigentlichen Näherungsschalter mit den weiteren Elementen der erfindungsgemässen Prüf- und Überwachungsschaltung zusammengefasst werden kann.

Beim Ausführungsbeispiel ist die Steuerschaltung als astabiler Multivibrator 10 ausgebildet. Wie Fig. 2 zeigt, besteht dieser astabile Multivibrator aus Widerständen R17 bis R20, Kondensatoren C4 und C5 und Transistoren T8, T9 und aus Dioden D4 und D5. Aufgrund des in Fig. 2 gezeigten Schaltungsaufbaus ist bei dem Multivibrator 10 beim Einschalten der Betriebsspannung ein sicheres Anschwingen gewährleistet, wobei die Dioden D4 und D5 dazu dienen, die Basisanschlüsse der Transistoren T8, T9 gegen negative Spannungsspitzen zu schützen, wie sie im Umschaltmoment auftreten.

Bei dem Multivibrator 10 gemäss Fig. 2 bildet der Kollektor des Transistors T8 den Ausgang der Schaltung, über den der eigentliche Bedämpfungskreis mit dem Transistor T7 und dem in Reihe dazu geschalteten Widerstand R14 steuerbar ist, wobei diese Reihenschaltung aus dem Widerstand R14 und dem Transistor T7 parallel zu den Tastkopfanschlüssen 1 und 3 und damit zur Teilwicklung L1 liegt, die folglich, wenn man von dem Begrenzungswiderstand R14 absieht, praktisch kurzgeschlossen werden kann. Dieses Kurzschliessen der Teilwicklung L1 erfolgt beispielsweise mit einer Taktfrequenz von 140 Hz und simuliert jeweils eine Bedämpfung des Oszillators des Näherungsschalters 8, an dessen Ausgang A somit ein getaktetes bzw. ein dynamisches Ausgangssignal zur Verfügung steht.

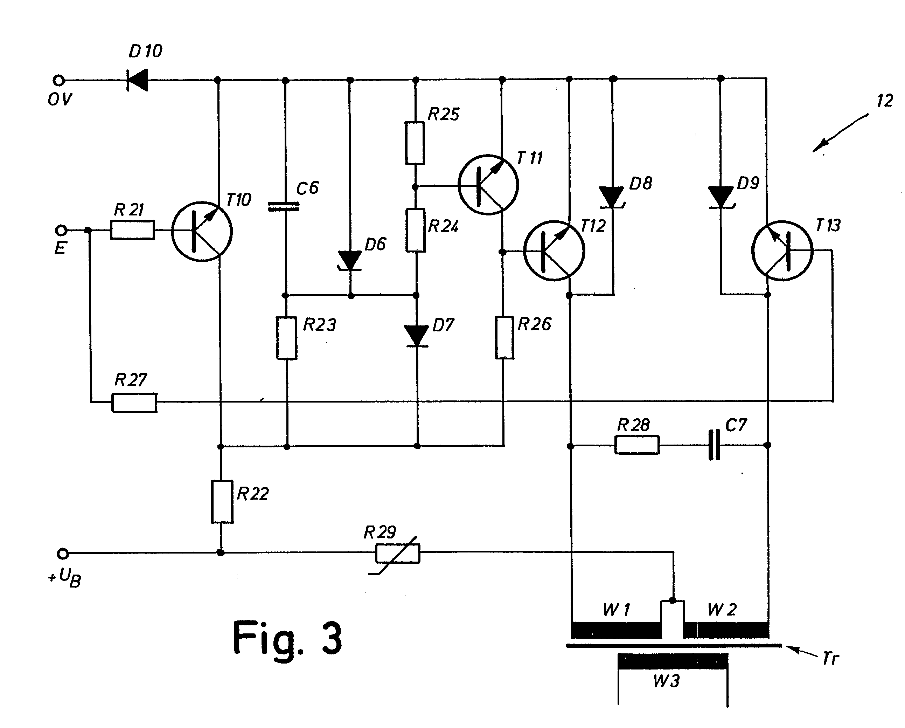

Gemäss Fig. 3 wird das Ausgangssignal des Näherungsschalters 8 der Ansteuerschaltung 12 an deren Eingang E zugeführt, welcher über einen Widerstand R21 mit der Basis eines Transistors T10 und über einen Widerstand R27 mit der Basis eines Transistors T13 verbunden ist. Dabei sind die Emitter der Transistoren T10 und T13 über eine Diode D10 mit dem einen Versorgungsanschluss (OV) der Ansteuerschaltung verbunden. Der Kollektor des Transistors T10 ist über einen Widerstand R22 mit dem anderen Versorgungsspannungsanschluss $+U_B$ und ausserdem über einen Kaltleiter R29 mit der Mittelanzapfung des Transformators Tr verbunden, über den die Ansteuerschaltung 12 induktiv mit der Relaisschaltung 14 gemäss Fig. 4 gekoppelt ist. Durch die Mittelanzapfung ist die Primärseite des Transformators in zwei Teilwicklungen w1 und w2 geteilt, deren von der Mittelanzapfung abgewandte Anschlüsse einerseits mit dem Kollektor des Transistors T13 und andererseits mit dem Kollektor eines weiteren Transistors T12 verbunden sind. Die Emitter der Transistoren T12, T13 sind dabei wieder über die Diode D10 mit dem ersten Anschluss (OV) verbunden. Parallel zu den Kollektor-Emitter-Strecken der Transistoren T12, T13 liegt jeweils eine Z-Diode D8 bzw. D9, während die Kollektoren der genannten Transistoren über die Reihenschaltung eines Widerstandes R28 und eines Kondensators C7 verbunden sind. Die Basis des Transistors T12 ist einerseits über einen Widerstand R26 mit dem Kollektor des Transistors T10 und andererseits mit dem Kollektor eines weiteren Transistors T11 verbunden, dessen Emitter über die Diode D10 mit dem ersten Anschluss (OV) der Ansteuerschaltung 12 verbunden ist. Mit diesem Anschluss ist auch die Basis des Transistors T11 über einen Widerstand R25 verbunden, der in Reihe mit einem Widerstand R24 liegt. Parallel zu der Serienschaltung der Widerstände R24 und R25 liegt dabei eine weitere Z-Diode D6 sowie ein Kondensator C6. Der gemeinsame Verbindungspunkt des Kondensators C6, der Z-Diode D6 und des Widerstandes R24 ist über die Parallelschaltung eines Widerstandes R23 und einer Diode D7 mit dem Kollektor des Transistors T10 verbunden. Die in Fig. 3 gezeigte Ansteuerschaltung arbeitet wie folgt:

Das von dem Näherungsschalter 8 eintreffende getaktete Signal, welches gemäss Fig. 5a eine Rechteckimpulsfolge mit einem unteren Pegel von etwa OV und einem oberen Pegel von etwa $+U_B$ ist, teilt sich am Eingang E der Ansteuerschaltung 12 auf und wird einerseits über den Widerstand R27 der Basis des Transistors T13 und andererseits über die Invertierstufe mit dem Transistor T10 der Basis des Transistors T12 zugeführt.

Wenn das Signal dabei seinen niedrigen Pegel (OV) besitzt, dann ist der Transistor T10 gesperrt, während der Transistor T12 über die Widerstände R22 und R26 einen Basisstrom erhalten kann und somit leitend gesteuert wird. Es fliesst nunmehr ein Strom von der positiven Anschlussklemme

(+U_B) über den Kaltleiter R29 durch die Teilwicklung W1 des Transformators Tr und über den leitenden Transistor T12 zu dem anderen Anschluss (OV) der Schaltung.

Wenn das Ausgangssignal des Näherungsschalters 8 dann auf den hohen Pegel (+U_B) springt, dann werden die Transistoren T10 und T13 leitend gesteuert, während der Transistor T12 sperrt. Der Strom fliesst nunmehr von der positiven Anschlussklemme +U_B über den Kaltleiter R29 durch die Teilwicklung W2 und den Transistor T13 zum anderen Anschluss der Schaltung. Entsprechend dem Wechsel der Schaltzustände der Transistoren T12 und T13 werden also abwechselnd die Teilwicklungen W1 und W2 der Primärwicklung des Transformators Tr von einem Strom durchflossen. Da die Mittelanzapfung der Primärwicklung mit dem positiven Anschluss der Schaltung verbunden ist, ergibt sich folglich bei gleichem Wicklungssinn der beiden Teilwicklungen W1 und W2 ein magnetischer Fluss, der je nach dem gerade eingeschalteten Strompfad eine positive oder eine negative Richtung annimmt. Dadurch entsteht auf der Sekundärseite des Transformators Tr in einer Sekundärwicklung W3 eine nullpunktsymmetrische, nahezu rechteckförmige Wechselspannung, die anschliessend zur Speisung der Relaisschaltung 14 gemäss Fig. 4 weiter aufbereitet wird.

Wenn der Näherungsschalter 8 nun beispielsweise zu einem Zeitpunkt t durch ein dicht genug herangeführtes Metallteil M bedämpft wird, dann ergibt sich an seinem Ausgang ein statisches Signal niedrigen Pegels, während an den Kollektoren der Transistoren T10 und T13 gemäss Fig. 5b die Potentialwechsel ebenfalls aufhören und ein statisches Signal hohen Pegels erscheint. Hält dieser statische Zustand längere Zeit an, dann könnte der Transistor T12 thermisch überlastet werden, weil der Strom durch diesen Transistor nur durch den geringen Gleichstromwiderstand der Teilwicklung W1 begrenzt wird. Der Transistor T12 muss daher nach einer gewissen Zeit abgeschaltet werden, was beim Ausführungsbeispiel in der Weise geschieht, dass über die Widerstände R22 und R23 der Kondensator C6 nach einer e-Funktion aufgeladen wird, bis über dem Kondensator C6 eine Spannung ansteht, die ausreicht, um über den Abgriff des Spannungsteilers R24, R25 den Transistor T11 leitend zu steuern. Sobald dies geschieht, wird die Basis des Transistors T12 auf das Potential OV geschaltet, so dass der Transistor T12 sperrt. Die Dimensionierung der Bauelemente C6, R23, R24 und R25 erfolgt dabei so, dass die Abschaltung bzw. Sperrung des Transistors T12 nach einem Zeitintervall a erfolgt, wie dies aus Fig. 5c deutlich wird, wo der Spannungsverlauf über dem Kondensator C6 dargestellt ist. Man erkennt, dass die Dauer des Zeitintervalls a etwa der doppelten Tastzeit des dynamischen Ausgangssignals des Näherungsschalters entspricht.

Wird der Eingang E des die Ansteuerschaltung 12, den Transformator Tr und die Relaisschaltung 14 umfassenden Auswertekreises 9 versehentlich mit der positiven Betriebsspannung verbunden, dann kann hierdurch in entsprechender Weise eine thermische Überlastung des Transistors T13 erfolgen. Aus diesem Grund ist in den mit der positiven Speisespannung +U_B verbundenen Anschluss der Kaltleiter R29 eingefügt, dessen Ansprechzeit 3 bis 4 s beträgt, wenn eine Teilwicklung W1 bzw. W2 der Primärwicklung des Transformators Tr ständig von einem Gleichstrom durchflossen wird, und der so dimensioniert ist, dass der Schalttransistor T13 und der Transformator Tr gegen eine unzulässige Erwärmung geschützt werden.

Wenn nach einer Bedämpfung oder auch nach einer Störung, die beispielsweise dadurch verursacht werden kann, dass in den Adern der Verbindungsleitung vom Näherungsschalter zur Ansteuerschaltung ein Kurzschluss eintritt, dass der Ausgangstransistor T6 des Näherungsschalters durchlegiert oder dass eine Verpolung stattgefunden hat, wieder einige Takte des Ausgangssignals erzeugt werden, dann muss der Kaltleiter R29 zunächst während eines Zeitintervalls von etwa 30 bis 40 Sekunden abkühlen, bis die Schaltung den Normalbetrieb wieder aufnehmen kann. Im übrigen ist der Spannungsverlauf am Kollektor des Transistors T12 in Fig. 5d dargestellt, während der Spannungsverlauf auf der Sekundärseite des Transformators Tr in Fig. 5e gezeigt ist.

Wie Fig. 4 zeigt, sind die Anschlüsse der Sekundärwicklung W3 des Transformators Tr mit einem Brückengleichrichter B verbunden, über den die Speisung der Relaisschaltung 14 erfolgt. Der positive Ausgangsanschluss des Brückengleichrichters B ist mit dem einen Anschluss eines ersten Relais Rel 1 verbunden, dessen zweiter Anschluss über Ruhekontakte 2d und 2c eines zweiten Relais Rel 2 mit dem negativen Anschluss des Gleichrichters B verbunden ist. Mit diesem negativen Anschluss ist der zweite Anschluss des Relais Rel 1 ausserdem über einen seiner Arbeitskontakte 1f verbindbar. Zwischen den Ausgangsanschlüssen des Brückengleichrichters B liegt ferner die Reihenschaltung eines Ruhekontakts 1e des ersten Relais Rel 1, eines Widerstandes R30 und eines Kondensators C9.

Der erste Anschluss des zweiten Relais Rel 2 ist ebenfalls mit dem positiven Ausgang des Brückengleichrichters B verbunden, während der zweite Anschluss des zweiten Relais Rel 2 über die Schaltstrecke eines Thyristors Th mit dem negativen Anschluss des Brückengleichrichters B verbunden ist. Die Steuerelektrode des Thyristors Th ist dabei einerseits über einen Widerstand R32 mit dem negativen Anschluss des Brückengleichrichters B verbunden und andererseits über die Serienschaltung eines Widerstandes R31 und eines Arbeitskontaktes 1d des ersten Relais Rel 1 mit dem Verbindungspunkt des Widerstandes R30 und des Kondensators C9. Parallel zu den beiden Relais Rel 1 und Rel 2 liegt ausserdem jeweils eine Freilaufdiode D11 bzw. D12, während die beiden Ausgangsanschlüsse des Brückengleichrichters B über einen Kondensator C8 miteinander verbunden sind, der der Glättung der Ausgangsspannung des Brückengleichrichters dient.

Aus der vorstehenden Beschreibung des Aufbaus der Relaisschaltung 14 anhand der Fig. 4 wird deutlich, dass die zum Betrieb der Relaisschaltung erforderliche elektrische Energie nur aus der Sekundärwicklung W3 des Transformators Tr entnommen werden kann. Dies setzt voraus, dass die Primärwicklung W1, W2 von einem Strom durchflossen wird, der ständig seine Richtung wechselt. Nur in diesem Fall wird von der Primärwicklung ein magnetisches Wechselfeld erzeugt, welches in der Sekundärwicklung W3 eine Wechselspannung zur Folge hat. Gleichspannungssignale auf der Primärseite des Transformators Tr können dagegen ungeachtet des Gleichspannungspegels nicht zu einer bleibenden Durchschaltung der Relais Rel 1 und Rel 2 der Relaisschaltung 14 führen.

Grundsätzlich würde es schon genügen, mit der gleichgerichteten Spannung vom Ausgang des Transformators Tr bzw. des Brückengleichrichters B ein einziges Relais anzusteuern, welches anzieht, wenn der Transformator Tr eine Ausgangsspannung liefert und abfällt, wenn diese Spannung aufgrund einer Bedämpfung des Näherungsschalters oder aufgrund einer Störung endet. Wenn jedoch bei diesem einfachen Schaltungskonzept die Kontakte des Relais verschweissen oder wenn das Relais wegen mechanischer Defekte hängen bleibt, dann ergibt sich am Ausgang der Relaisschaltung keine zuverlässige Störungsmeldung. Der beschriebene Überwachungsaufwand für den Näherungsschalter selbst würde folglich nichts nützen. Aus diesem Grunde werden gemäss einer Weiterbildung der Erfindung zwei Relais Rel 1 und Rel 2 verwendet, wobei von der Voraussetzung ausgegangen wird, dass niemals der Fall eintritt, dass beide Relais gleichzeitig einen solchen Defekt aufweisen, dass sie im Arbeitszustand bzw. im durchgeschalteten Zustand hängen bleiben. Die zwei Relais werden nun aber nicht einfach parallel geschaltet, da in diesem Fall kein Warnsignal erzeugt werden könnte, wenn eines der Relais hängen bleibt, so dass letztlich wieder eine ähnlich geringe Sicherheit wie bei der Verwendung nur eines Relais erreicht würde. Vielmehr sind die beiden Relais Rel 1 und Rel 2 bei der Relaisschaltung 14 so geschaltet, dass sie sich gegenseitig überwachen, das heisst derart, dass eine Fehlermeldung bereits dann ausgelöst wird, wenn auch nur eines der beiden Relais hängen bleibt, wobei in diesem Fall die Hauptkontaktstrecke 16 der Maschinensteuerung mit den Arbeitskontakten 1a und 2a der Relais Rel 1 bzw. Rel 2 unterbrochen bleibt.

Im einzelnen arbeitet die Relaisschaltung 14 gemäss Fig. 4 wie folgt:

Beim Einschalten der Schaltung, das heisst, wenn auf der Sekundärseite des Transformators Tr eine Wechselspannung auftritt, führt dies dazu, dass die gleichgerichtete Spannung am Ausgang des Brückengleichrichters B zunächst das Relais Rel 1 über den Strompfad mit den Ruhekontakten 2d und 2c zum Anziehen bringt. Gleichzeitig wird der Kondensator C9 über den Ruhekontakt 1e und den Widerstand R30 auf eine für die Zündung des Thyristors Th ausreichende Spannung aufgeladen. Wenn das Relais Rel 1 dann nach Aufbau seines Magnetfeldes anzieht, dann werden die Kontakte dieses Relais entsprechend betätigt, wobei aufgrund der Tatsache, dass es sich bei dem Relais Rel 1 um ein Relais mit zwangsgeführten Kontakten handelt, zunächst die Ruhekontakte geöffnet werden und erst dann die Arbeitskontakte geschlossen werden. Dies bedeutet, dass der Kondensator C9 durch Öffnen des Ruhekontaktes 1e zunächst vom positiven Anschluss des Brückengleichrichters B getrennt wird und erst kurze Zeit später über den Arbeitskontakt 1d mit der Steuerelektrode des Thyristors Th verbunden wird. Wenn dies geschieht, schaltet der Thyristor Th durch, so dass nunmehr auch das zweite Relais Rel 2 anziehen kann, wobei seine Ruhekontakte 2c und 2d geöffnet werden. Da sich das erste Relais Rel 1 inzwischen über seinen Arbeitskontakt 1f selbst hält, sind nunmehr die beiden Arbeitskontakte 1a und 2a in der Hauptkontaktstrecke 16 der Maschinensteuerung geschlossen und bleiben geschlossen, bis das dynamische Wechselspannungssignal auf der Ausgangsseite des Transformators Tr endet, was dann geschieht, wenn der Näherungsschalter durch ein Metallteil M bedämpft wird, oder wenn eine der zu überwachenden Störungen auftritt.

Aus der vorstehenden Beschreibung wird deutlich, dass gemäss der Erfindung eine Prüf- und Überwachungsschaltung geschaffen wurde, die nicht nur geeignet ist, die Funktionsfähigkeit eines prüfbaren Näherungsschalters kontinuierlich zu überwachen, sondern die darüber hinaus so aufgebaut ist, dass unter Ausnutzung des dynamischen Ausgangssignals des störungsfrei arbeitenden Näherungsschalters auch eine Selbstüberwachung aller wesentlichen Schaltungskomponenten der Überwachungsschaltung erfolgt. Auf diese Weise wird für die Freigabe und Sperrung der mit dem Näherungsschalter verbundenen Maschinensteuerung eine extrem hohe Sicherheit erreicht, wie dies aus der nachfolgenden Liste der Fehlermöglichkeiten in der Relaisschaltung deutlich wird, in der die einzelnen Bauteile nur mit ihren Bezugszeichen bezeichnet sind und in der ausserdem die Abkürzung HKS zur Bezeichnung der Hauptkontaktstrecke 16 verwendet wird.

Dabei spielt es bei der Realisierung der Erfindung im Prinzip keine Rolle, ob der Näherungsschalter als Öffner oder Schliesser eingesetzt ist und ob der Näherungsschalter im Normalfall bedämpft oder entdämpft bzw. aktiviert oder nicht aktiviert ist.

**Fehlermöglichkeiten in der Relaisschaltung**

| Bauteil | Wirkung, wenn Relais in Arbeitsstellung festhängt | HKS unterbr. durch | in Ruhestellung festhängt | HKS unterbr. durch |
|---|---|---|---|---|
| Rel 1 | Anzug von Rel 2 wird verhindert, da keine Aufladung von C9 und folglich kein Zündimpuls für Th. | 2a | Anzug von Rel 2 wird verhindert, da kein Zündimpuls für Th. Ausserdem HKS durch eigenen Kontakt unterbrochen | 1a, 2a |
| Rel 2 | Anzug von Rel 1 wird verhindert, da Spgs-versorgung über 2c/2d unterbrochen | 1a | HKS durch eigenen Kontakt unterbrochen | 2a |

| Kontakt | Wirkung, wenn Rel.-Kont. verschmutzt oder seine Zuleitg. unterbr. ist | | | HKS unterbr. durch |
|---|---|---|---|---|
| 1a | HKS ist unterbrochen | | | 1a |
| 1d | Kein Zündimpuls für Th, Anzug von Rel 2 wird verhindert | | | 2a |
| 1e | Kein Aufladen von C9, somit kein Zündimpuls für Th, Anzug von Rel 2 wird verhindert | | | 2a |
| 1f | Selbsthaltung von Rel 1 wird verhindert, es fällt sofort wieder ab | | | 1a |
| 2a | HKS ist unterbrochen | | | 2a |
| 2c/2d | Anzug von Rel 1 wird verhindert, somit auch Anzug von Rel 2 | | | 1a, 2a |

| Bauteil | Wirkung, wenn Bauteil = 0Ω wird (durchlegiert) | HKS unterbr. durch | = ∞ Ω wird (sich ablöst oder verbrennt) | HKS unterbr. durch |
|---|---|---|---|---|
| Th1 | Rel 2 zieht sofort an und unterbricht mit 2c/2d die Spannungszufuhr für Rel 1 | 1a | Anzug von Rel 2 wird verhindert | 2a |
| D11 | Anzug von Rel wird verhindert, somit auch von Rel 2 | 1a, 2a | Keine sofortige Auswirkung Auf Dauer evtl. Beschädigung von 1f | – |
| D12 | Anzug von Rel 2 wird verh. | 2a | Keine direkte Auswirkung | – |
| R30 | Keine direkte Auswirkung | – | Kein Zündstrom für Th, Anzug von Rel 2 wird verhindert | 2a |
| R31 | Keine sofortige Auswirkung; auf Dauer Zerstörung von Th | – | Kein Zündstrom für Th, Anzug von Rel 2 wird verhind. | 2a |
| R32 | Zündestrom für Th wird abgeleitet, Anzug bon Rel 2 wird verhindert | 2a | Keine direkte Auswirkung | – |
| B | Ungenügende Speisespannung | (1a, 2a) | Ungenügende Speisespannung | (1a, 2a) |
| C8 | Kurzschluss für Speisespg. | 1a/2a | Speisespg. sinkt periodisch auf 0 ab. Kein Haltestrom für Th | 2a |
| Trafo | Windungs- od. gar Wicklungskurzschluss ergibt ungenügende oder gar keine Speisespg. (Schluss von Primärw. nach Sekundärw. wird durch konstruktive Massnahmen ausgeschlossen) | 1a, 2a | Unterbrechung in einer Wicklung ergibt halbe oder gar keine Speisespannung | 1a, 2a |

## Patentansprüche

1. Prüf- und Auswerteschaltung für die einwandfreie Funktion eines als Element einer Maschinensteuerung vorgesehenen, durch Änderung seines Schaltzustandes auf seine Funktionsfähigkeit prüfbaren Näherungsschalters (8) mit einer Steuerschaltung (10), durch die der Näherungsschalter (8) mit einer solchen Frequenz zwischen seinen beiden Schaltzuständen umsteuerbar ist, dass er an seinem Ausgang (A) ein für eine transformatorische Übertragung geeignetes, getaktetes Ausgangssignal erzeugt, und mit einem mit dem Ausgang des Näherungsschalters (8) verbundenen Auswertekreis (9), der für die Dauer des Vorliegens des getakteten Ausgangssignals des

8

Näherungsschalters (8) ein Freigabesignal und beim Ausbleiben des getakteten Ausgangssignals des Näherungsschalters (8) ein Sperrsignal für die Maschinensteuerung erzeugt und der eine die Maschinensteuerung überwachende Relaisschaltung (14) umfasst, der das getaktete Ausgangssignal des Näherungsschalters (8) bzw. ein davon abgeleitetes Signal über einen zum Auswertekreis (9) gehörigen und zwischen dem Ausgang (A) des Näherungsschalters (8) und der Relaisschaltung (14) liegenden Transformator (Tr) zuführbar ist.

2. Schaltung nach Anspruch 1, wobei der Auswertekreis (9) eine zwischen dem Ausgang (A) des Näherungsschalters (8) und dem Transformator (Tr) liegende Ansteuerschaltung (12) aufweist, durch die dem Transformator (Tr) das verstärkte, getaktete Ausgangssignal des Näherungsschalters zuführbar ist.

3. Schaltung nach Anspruch 2, wobei die Ansteuerschaltung (12) Verstärkereinrichtungen (18, 20) für das Ausgangssignal des Näherungsschalters (8) und Sperreinrichtungen (T11; R29) zum Schutz des Transformators (Tr) gegen eine Überlastung bei Ausbleiben der Potentialwechsel des Ausgangssignals des Näherungsschalters (8) zwischen einem ersten und einem zweiten Potential aufweist.

4. Schaltung nach einem der Ansprüche 1 bis 3, wobei die Relaisschaltung (14) zwei Relais (Rel 1, Rel 2) enthält, die jeweils einen Arbeitskontakt (1a, 2a) besitzen, und wobei die Arbeitskontakte (1a, 2a) in Serie zueinander in eine Hauptkontaktstrecke (16) der Maschinensteuerung eingefügt sind.

5. Schaltung nach Anspruch 4, wobei die beiden Relais (Rel 1, Rel 2) der Relaisschaltung (14) derart geschaltet sind, dass sie sich in ihrer Funktion gegenseitig überwachen.

6. Schaltung nach Anspruch 5, wobei das eine der beiden Relais (Rel 1) der Relaisschaltung (14) direkt mit dem gleichgerichteten Ausgangsstrom des Transformators (Tr) angesteuert wird, wobei durch den gleichgerichteten Ausgangsstrom des Transformators (Tr) einKondensator (C9) aufladbar ist, wobei der Kondensator (C9) über einen Arbeitskontakt (1d) des ersten Relais (Rel 1) als Zündimpulsquelle mit der Steuerelektrode eines steuerbaren Halbleitergleichrichters (Th) verbunden ist und wobei die Schaltstrecke des steuerbaren Halbleitergleichrichters (Th) im Erregerstromkreis des zweiten Relais (Rel 2) angeordnet ist.

7. Schaltung nach Anspruch 3, wobei die Sperreinrichtungen der Ansteuerschaltung (12) einen Schalttransistor (T11) aufweisen, der über ein Zeitglied (R23, C6) bei Andauern des ersten Potentials des Ausgangssignals des Näherungsschalters (8) zur Sperrung eines zu dem Transformator (Tr) fliessenden Stroms verzögert geschaltet wird, und wobei Sperreinrichtungen ferner einen Kaltleiter (R29) umfassen, der bei Andauern des zweiten Potentials des Ausgangssignals des Näherungsschalters (8) zur Sperrung eines Stroms durch den Transformator (Tr) verzögert wirksam wird. .

8. Schaltung nach einem der Ansprüche 1 bis 7, bei der ein induktiver oder kapazitiver Näherungsschalter eingesetzt ist, wobei die Steuerschaltung einen astabilen Multivibrator (10) zur Ansteuerung des Bedämpfungskreises (T7, R14) aufweist.

9. Schaltung nach Anspruch 8 für einen Näherungsschalter mit einem im Schwingkreis des Oszillators angeordneten, induktiven, eine Tastkopfspule mit Anzapfung enthaltenden Tastkopf, wobei durch den Multivibrator (10) für einen zwischen der Anzapfung und einem der äusseren Spulenanschlüsse liegenden Wicklungsteil (L1) der Testkopfspule (L) ein Kurzschluss herbeigeführt wird.

10. Schaltung nach Anspruch 9, wobei der Kurzschluss unmittelbar mittels eines zu dem Spulenteil (L1) parallelgeschalteten, durch den Multivibrator (10) gesteuerten Schaltertransistor (T7) herbeigeführt wird.

11. Schaltung nach Anspruch 10, wobei in den Kurzschlusskreis ein definierter Reihenwiderstand (R14) eingefügt ist.

12. Schaltung nach Anspruch 10 oder 11, wobei der Kollektor des Schalttransistors (T7) mit der Anzapfung der Tastkopfspule (L) verbunden ist, wobei der Emitter des Schalttransistors (T7) mit einem mit dem einen Pol (OV) einer Speisespannungsquelle verbundenen äusseren Anschluss (3) der Tastkopfspule (L) verbunden ist und wobei die Basis des Schalttransistors (T7) mit dem Ausgang des Multivibrators (10) verbunden ist.

13. Schaltung nach einem der Ansrpüche 1 bis 7, bei der ein einen Lichtsender aufweisender optischer Näherungsschalter eingesetzt ist, wobei der Lichtsender des Näherungsschalters (8) durch die Steuerschaltung (10) mit vorgegebener Frequenz ein- und ausschaltbar ist.

## Claims

1. A testing and evaluating circuit for the trouble-free operation of a proximity switch (8) which is provided as an element of a control system of a machine and testable with respect to its operability by changing its switching state, having a control circuit (10), by means of which the proximity switch (8) is reversible at a frequency between its two switching states such that at its output (A) it generates a clock-timed output signal suitable for a transformer transmission, and having an evaluating circuit (9) which is connected to the output of the proximity switch (8) and which generates a release signal for the duration of the existence of the clock-timed output signal of the proximity switch (8) and a blocking signal in the absence of the clock-timed output signal of the proximity switch (8) and which comprises a relay connexion (14) which monitors the machine control system and to which is suppliable the clock-timed output signal of the proximity switch (8) or a signal derived therefrom by way of a transformer (Tr) associated with the evaluating circuit (9) and interposed between the output (A) of the proximity switch (8) and the relay connexion (14).

2. A circuit according to Claim 1, wherein the evaluating circuit (9) comprises a triggering circuit (12) which is interposed between the output (A) of the proximity switch (8) and the transformer (Tr) and by means of which the amplified clock-timed output signal of the proximity switch is suppliable to the transformer (Tr).

3. A circuit according to Claim 2, wherein the triggering circuit (12) comprises amplifier devices (18, 20) for the output signal of the proximity switch (8) and blocking devices (T11; R29) for protecting the transformer (Tr) from overloading in the absence of a change in the potential of the output signal of the proximity switch (8) between a first and a second potential.

4. A circuit according to any one of Claims 1 to 3, wherein the relay connexion (14) comprises two relays (Rel 1, Rel 2) each of which comprise an operating contact (1a, 2a), and the operating contacts (1a, 2a) are inserted in series with one another in a main contact path (16) of the machine control system.

5. A circuit according to Claim 4, wherein the two relays (Rel 1, Rel 2) of the relay connexion (14) are connected in such a way that they monitor themselves reciprocally in their operation.

6. A circuit according to Claim 5, wherein one of the two relays (Rel 1) of the relay connexion (14) is directly triggered by the rectified output current of the transformer (Tr), a capacitor (C9) is chargeable by the rectified output current of the transformer (Tr), the capacitor (9) is connected to the control electrode of a controllable semiconductor rectifier (Th) by way of an operating contact (1d) of the first relay (Rel 1) as an ignition impulse source, and the switching path of the controllable semiconductor rectifier (Th) is arranged in the exciting current circuit of the second relay (Rel 2).

7. A circuit according to Claim 3, wherein the blocking devices of the triggering circuit (12) comprise a switching transistor (T11) which is connected with a delay by way of a time function element (R23, C6) for the duration of the first potential of the output signal of the proximity switch (8) in order to block a current flowing to the transformer (Tr), and the blocking devices further comprise a cold conductor (R29) which is effective with a delay for the duration of the second potential of the output signal of the proximity switch (8) in order to block a current through the transformer (Tr).

8. A circuit according to any one of Claims 1 to 7, in which an inductive or capacitive proximity switch is included, wherein the control circuit comprises an astable multivibrator (10) for triggering the attenuation circuit (T7, R14).

9. A circuit according to Claim 8 for a proximity switch with an inductive sensing head which is arranged in the oscillating circuit of the oscillator and which comprises a sensing head coil with a tap, wherein a short circuit is produced by the multivibrator (10) for a portion (L1) of the winding of the sensing head coil (L) interposed between the tap and one of the outer coil terminals.

10. A circuit according to Claim 9, wherein the short circuit is directly produced by means of a switching transistor (T7) connected in parallel with the part (L1) of the coil and controlled by the multivibrator (10).

11. A circuit according to Claim 10, wherein a defined series resistor (R14) is inserted in the shorted circuit.

12. A circuit according to Claim 10 or 11, wherein the collector of the switching transistor (T7) is connected to the tap of the sensing head coil (L), the emitter of the switching transistor (T7) is connected to an outer terminal (3) of the sensing head coil (L) connected to one pole (OV) of a supply voltage source, and the base of the switching transistor (T7) is connected to the output of the multivibrator (10).

13. A circuit according to any one of Claims 1 to 7, in which an optical proximity switch comprising a light emitter is included, wherein the light emitter of the proximity switch (8) is switchable on and off by the control circuit (10) at a predetermined frequency.

**Revendications**

1. Circuit d'essai et d'évaluation du fonctionnement correct d'un détecteur de proximité (8) prévu en tant qu'élément de commande d'une machine, pouvant être essayé en ce qui concerne sa capacité de fonctionnement par modification de son état de commutation, comprenant un circuit de commande (10) au moyen duquel le détecteur de proximité (8) peut être commuté entre ses deux états de commutation selon une fréquence telle qu'il produit à sa sortie (A) un signal de sortie rythmé et propre à une transmission à un transformateur, et comprenant un circuit d'évaluation (9) relié à la sortie du détecteur de proximité (8), qui produit pendant la durée de la présence du signal de sortie rythmé du détecteur de proximité (8) un signal d'habilitation et pendant l'absence du signal de sortie rythmé du détecteur de proximité (8) un signal de blocage pour la commande de la machine, et qui comprend un circuit à relais (14) contrôlant la commande de la machine, auquel peut être appliqué le signal de sortie rythmé du détecteur de proximité (8), ou un signal dérivé de ce dernier, par l'intermédiaire d'un transformateur (Tr) appartenant au circuit d'évaluation (9) et monté entre la sortie (A) du détecteur de proximité (8) et le circuit à relais (14).

2. Circuit selon la revendication 1, dans lequel le circuit d'évaluation (9) comprend un circuit d'excitation (12) monté entre la sortie (A) du détecteur de proximité (8) et le transformateur (Tr), par lequel le signal de sortie rythmé et amplifié du détecteur de proximité peut être appliqué au transformateur (Tr).

3. Circuit selon la revendication 2, dans lequel le circuit d'excitation (12) comprend des dispositifs d'amplification (18, 20) pour le signal de sortie du détecteur de proximité (8) et des dispositifs de blocage (T11; R29) pour protéger le transformateur (Tr) contre une surcharge lors de l'absence du changement de potentiel du signal de sortie du détecteur de proximité (8) entre un premier et un second potentiels.

4. Circuit selon l'une des revendications 1 à 3, dans lequel le circuit à relais (14) contient deux relais (Rel 1, Rel 2) qui comprennent chacun un contact de travail (1a, 2a), et dans lequel les contacts de travail (1a, 2a) sont montés en série l'un par rapport à l'autre dans un parcours de contact principal (16) de la commande de la machine.

5. Circuit selon la revendication 4, dans lequel les deux relais (Rel 1, Rel 2) du circuit à relais (14) sont branchés de manière qu'ils se contrôlent mutuellement sur le plan de leur fonctionnement.

6. Circuit selon la revendication 5, dans lequel l'un des deux relais (Rel 1) du circuit à relais (14) est excité directement par le courant de sortie redressé du transformateur (Tr), dans lequel un condensateur (C9) peut être chargé par le courant de sortie redressé du transformateur (Tr), dans leuquel le condensateur (C9) est relié par l'intermédiaire d'un contact de travail (1d) du premier relais (Rel 1) en tant que source d'impulsions d'amorçage à l'électrode de commande d'un redresseur à semiconducteur commandable (Th) et dans lequel le parcours de commutation du redresseur à semiconducteur commandable (Th) est disposé dans le circuit du courant d'excitation du second relais (Rel 2).

7. Circuit selon la revendication 3, dans lequel les dispositifs de blocage du circuit d'excitation (12) comprennent un transistor de commutation (T11), qui est rendu conducteur de façon retardée par l'intermédiaire d'un élément temporisateur (R23, C6) lorsque dure le premier potentiel du signal de sortie du détecteur de proximité (8) pour bloquer un courant allant au transformateur (Tr), et dans lequel les dispositifs de blocage comprennent en outre un conducteur à froid (R29) qui devient actif de façon retardée pour bloquer un courant traversant le transformateur (Tr) lorsque dure le second potentiel du signal de sortie du détecteur de proximité (8).

8. Circuit selon l'une des revendications 1 à 7, dans lequel est monté un détecteur de proximité inductif ou capacitif, le circuit de commande comprenant un multivibrateur astable (10) pour exciter le circuit d'amortissement (T7, R14).

9. Circuit selon la revendication 8, pour un détecteur de proximité avec une tête palpeuse inductive, disposée dans le circuit oscillant de l'oscillateur, contenant une bobine de tête palpeuse avec une prise, dans lequel un court-circuit est établi par le multivibrateur (10) pour une partie de l'enroulement (L1) de la bobine de la tête palpeuse (L) située entre la prise et l'un des raccords extérieurs de la bobine.

10. Circuit selon la revendication 9, dans lequel le court-circuit est établi directement au moyen d'un transistor de commutation (T7) monté parallèlement à la partie (L1) de la bobine, et commandé par le multivibrateur (10).

11. Circuit selon la revendication 10, dans lequel une résistance série définie (R14) est insérée dans le montage en court-circuit.

12. Circuit selon la revendication 10 ou 11, dans lequel le collecteur du transistor de commutation (T7) est relié à la prise de la bobine (L) de la tête palpeuse, dans lequel l'émetteur du transistor de commutation (T7) est relié à un raccord extérieur (3) de la bobine (L) de la tête palpeuse qui est relié à un pôle (OV) d'une source de tension d'alimentation, et dans lequel la base du transistor de commutation (T7) est reliée à la sortie du multivibrateur (10).

13. Circuit selon l'une des revendications 1 à 7, dans lequel est monté un détecteur de proximité optique possédant un émetteur de lumière, dans lequel l'émetteur de lumière du détecteur de proximité (8) peut être mis sous tension et hors tension selon une fréquence prédéterminée par le circuit de commande (10).

0 060 992

Fig. 1

Fig. 5

a)

b)

Schaltschwelle v. T11

c)

d)

e)

13

Fig. 2

0 060 992

Fig. 3

0 060 992

Fig. 4

0 060 992